# EUROPÄISCHE PATENTSCHRIFT

(11) **EP 3 064 281 B1**
(45) Veröffentlichungstag und Bekanntmachung des Hinweises auf die Patenterteilung: **04.01.2023**
(21) Anmeldenummer: 16152128.1
(22) Anmeldetag: 12.01.2010
(51) Int. Cl.: B05D 1/34, B41J 11/00, B41J 3/407, H05K 3/12, H05K 3/46, B05D 5/06, B05D 1/00, B05D 1/02

(54) **VERFAHREN ZUM BESCHICHTEN EINER OBERFLÄCHE SOWIE DIGITALES BESCHICHTUNGSSYSTEM**
METHOD FOR COATING A SURFACE AND DIGITAL COATING SYSTEM
PROCÉDÉ DE REVÊTEMENT D'UNE SURFACE AINSI DE SYSTÈME DE REVÊTEMENT NUMÉRIQUE

(30) Priorität: 16.01.2009 DE 102009004877
(43) Veröffentlichungstag der Anmeldung: 07.09.2016
(62) Teilanmeldung aus: 10000230.2
(73) Patentinhaber: Bauer, Jörg R., 88255 Baienfurt (DE)
(72) Erfinder: Bauer, Jörg R., 88255 Baienfurt (DE)
(74) Vertreter: Kramer Barske Schmidtchen Patentanwälte PartG mbB

(56) Entgegenhaltungen:
- EP-A1- 1 462 266
- WO-A1-02/00449
- DE-A1-102007 022 919
- US-A1- 2004 189 768

## Beschreibung

Die Erfindung betrifft ein Verfahren zum Beschichten einer Oberfläche mittels eines Auftragsbauteils mit einer Mehrzahl von digital angesteuerten Düsen, die Flüssigkeitströpfchen abspritzen. Die Erfindung betrifft weiter ein mittels des Verfahren beschichtetes Bauteil.

In der Praxis stellt sich in unterschiedlichsten Anwendungen die Aufgabe, eine Oberfläche beispielsweise eines Substrates mit einer oder mehreren Schichten zu versehen, deren Dicke unterschiedlich ist und/oder die in unterschiedlichen Teilbereichen unterschiedlich zusammengesetzt sind. Um Bauteile mit solchen Schichten zu versehen, sind unterschiedlichste Technologien bekannt, beispielsweise Mehrschicht- oder Mehrzonengießtechniken, Ätztechniken, Laserabtragverfahren usw.

In der DE 10 2007 022919 A1, von der im Oberbegriff des Anspruchs 1 ausgegangen wird, ist ein Verfahren beschrieben, gemäß dem ein Bauteil mit Hilfe des Tintenstrahldruckverfahrens mit einer Reliefflüssigkeit, die beispielsweise Alkohol und ein niederviskoses Bindemittel enthält und unter UV-Bestrahlung aushärtet, derart bedruckt bzw. beschichtet wird, dass eine Reliefoberfläche entsteht. Diese Reliefoberfläche wird dadurch hergestellt, dass die Reliefflüssigkeit zunächst in einer Menge aufgebracht wird, in der eine Schicht der erforderlichen Minimaldicke entsteht. Auf diese Schicht werden weitere Schichten aus Reliefflüssigkeit derart aufgebracht, dass das erwünschte Relief bzw. die erwünschte Konturierung entsteht. Auf die Reliefoberfläche wird mit Hilfe an sich bekannter Färbeflüssigkeiten ein Muster aufgedruckt.

Die DE 100 31 030 B4, offenbart ein Tintenstrahldruckverfahren, mit dem eine aus Holz bestehende Oberfläche mit einem Muster bedruckt wird, dessen Aussehen einer vorbestimmten Holzart mit einer vorbestimmten Einfärbung entspricht.

Die US 2003 0020767 A1 beschreibt eine Tintenstrahldruckvorrichtung zum Bedrucken einer Oberfläche mit einem Muster, insbesondere Holzmaserungsmuster, wobei zwischen dem Tintenstrahldruckkopf und der zu bedruckenden Oberfläche ein konstanter Abstand aufrechterhalten wird.

In der US 2003/0020767 A1 ist ein Verfahren zum Lackiern insbesondere eines Flugzeugs beschrieben, bei dem eine Lackmaterialausstoßeinrichtung, besispielsweise ein Tintenstrahldruckkopf, entlang einer gekrümmten Oberfläche mechanisch geführt wird und die Lackmaterialausstoßeinrichtung und die Führungseinrichtung von einer Steuereinrichtung derart gesteuert werden, dass die Oberfläche in gewünschter Weise lackiert wird. Dabei können unterschiedliche Lacke verwendet werden, auch solche Lacke, an deren Oberfläche eine Riblet-Struktur erzeugt werden kann. Solche Riblet-Strukturen werden durch mechanische Prägung der lackierten Oberfläche hergestellt.

Der Erfindung liegt die Aufgabe zugrunde, ein Verfahren , mit dem sich in kostengünstiger Weise Oberflächen herstellen lassen, die unterschiedliche funktionale Anforderungen erfüllen, und ein mit einem solchen Verfahren hergestelltes Bauteil anzugeben.

Der auf das Verfahren gerichtete Teil der Aufgabe wird mit dem Merkmalen des Anspruchs 1 gelöst. Der auf das Bauteil gerichtete Teil der Aufgabe wird mit den Merkmalen des Anspruchs 6 gelöst. Weiterbildungen sind in den abhängigen Ansprüchen angegeben.

Die Erfindung, die für unterschiedlichste Anwendungen eingesetzt werden kann, wird im Folgenden anhand von Figuren beispielsweise und mit weiteren Einzelheiten erläutert.

In den Figuren stellen dar:
- Fig. 1: eine Prinzipansicht einer in ihrem Grundaufbau an sich bekannten Vorrichtung, wie sie für die Erfindung eingesetzt werden kann,
- Fig. 2: eine Skizze zur Erläuterung des Aufbringens einer Schicht unterschiedlicher Dicke,
- Fig. 3: eine Skizze zur Erläuterung der Beschichtung einer gekrümmten Oberfläche,
- Fig. 4: eine Skizze zur Erläuterung einer weiteren Möglichkeit zur Beschichtung einer gekrümmten Oberfläche,
- Fig. 5: eine Skizze zur Erläuterung der Beschichtung einer unebenen Oberfläche,
- Fig. 6: eine weitere Skizze zur Erläuterung der Beschichtung einer unebenen Oberfläche,
- Fig. 7: eine Prinzipansicht eines vielseitig einsetzbaren digitalen Systems zur Beschichtung von Oberflächen, und
- Fig. 8: Beispiele von Beschichtungen, wie sie mit dem System gemäß Fig. 7 erzeugbar sind.

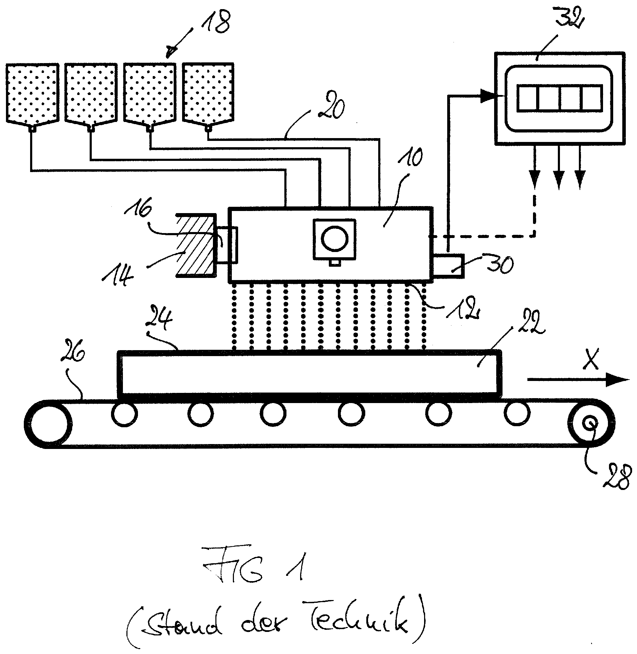

Fig. 1 zeigt eine Prinzipansicht eines an sich bekannten Systems zur Tintenstrahlbedruckung von Oberflächen. Gemäß Fig. 1 weist ein Auftragsbauteil 10 an seiner Unterseite eine Vielzahl von Düsen 12 auf. Das Auftragsbauteil 10 ist an einer ortsfesten Struktur 14 mittels einer Antriebseinheit 16 beweglich gehalten.

Ein Flüssigkeitsvorrat 18 enthält einen Vorrat von im dargestellten Beispiel 4 Flüssigkeiten, die jeweils über Leitungen 20 dem Auftragsbauteil 10 zuführbar sind.

Die Düsen 12 sind wahlweise oder permanent mit jeweils einer der Leitungen 20 verbunden und derart steuerbar, dass aus ihnen in zeitlich vorbestimmter Weise Flüssigkeitströpfchen abgespritzt werden, die vorzugsweise ein konstantes Volumen haben.

Den Düsen 12 gegenüber befindet sich ein Gegenstand 22 mit einer Oberfläche 24, die mittels des Auftragsbauteils 10 beschichtet werden soll. Der Gegenstand 22 befindet sich im dargestellten Beispiel auf einem umlaufenden Transportband 26, das mittels eines Motors, vorzugsweise eines Elektromotors 28 antreibbar ist, so dass der Gegenstand 22 im dargestellten Beispiel in Richtung des Pfeils X oder in Gegenrichtung dazu bewegbar ist.

Zur Erfassung der Position des Gegenstandes 22 bzw. von dessen Oberfläche relativ zu dem Auftragsbauteil 10 ist eine Sensoreinrichtung 30 starr mit dem Auftragsbauteil 10 verbunden oder ortsfest positioniert. Die Sensoreinrichtung ist bevorzugt derart ausgebildet, dass sie nicht nur die Position der Oberfläche 24 relativ zum Auftragsbauteil 10 erfasst, sondern auch die Art der Oberfläche bzw. einer auf der Oberfläche vorhandenen Schicht, deren Kontur usw.

Zur Steuerung des Auftragsbauteils 10, der Antriebseinheit 16 und des Motors 28 ist eine elektronische Steuereinrichtung 32 vorgesehen, deren Eingänge mit der Sensoreinrichtung 30 sowie vorteilhafterweise mit Stellungsgebern der Antriebseinheit 16 sowie des Motors 23 verbunden sind.

Die Steuereinrichtung 32 enthält ein Programm, entsprechend dem die Relativbewegung zwischen dem Auftragsbauteil 10, das im dargestellten Beispiel beispielsweise quer zur Richtung X horizontal (Y-Richtung) und vertikal (Z-Richtung) bewegbar ist, und dem Gegenstand 22 sowie koordiniert dazu das Abspritzen von Flüssigkeitströpfchen aus den Düsen 12 gesteuert wird, so dass die Oberfläche 24 entsprechend einem in der Steuereinrichtung 32 abgelegten Programm beschichtet wird.

Während bei einem konventionellen digitalen Druckverfahren, beispielsweise Tintenstrahldruckverfahren (bubble jet), die Färbeflüssigkeit in nebeneinander, gegebenenfalls in gegenseitiger Überlappung, aufgebrachten Tröpfchen aufgetragen wird, kann nach einem weiteren Verfahren eine Schicht auf die Oberfläche 24 aufgebracht werden, indem ein zu beschichtender Flächenbereich mehrfach mit Flüssigkeitströpfchen beschichtet wird, bis eine vorbestimmte Schichtdicke aufgetragen ist. Das Fließ- und Trocknungsverhalten der Flüssigkeit ist dabei auf die Relativgeschwindigkeit zwischen Auftragselement 10 und Oberfläche 24 derart abgestimmt, dass auch scharf abgestufte Flüssigkeitsschichten aufgebracht werden können. Wenn eine Flüssigkeitströpfchenschicht auf eine bereits aufgebrachte Flüssigkeitströpfchenschicht aus derselben Flüssigkeit aufgebracht wird, lösen die frischen Flüssigkeitströpfchen vorteilhafterweise die bereits aufgebrachte Flüssigkeitsschicht an und verfließen mit dieser zu einer homogenen Flüssigkeitsschicht größerer Dicke. Auf diese Weise kann auf einen vorbestimmten Oberflächenbereich eine Schicht vorbestimmter Dicke aufgebracht werden, deren Dicke entsprechend dem Beschichtungsprogramm entsprechend der Anzahl der auf dem jeweiligen Flächenbereich aufgebrachten Tröpfchenschichten unterschiedlich sein kann.

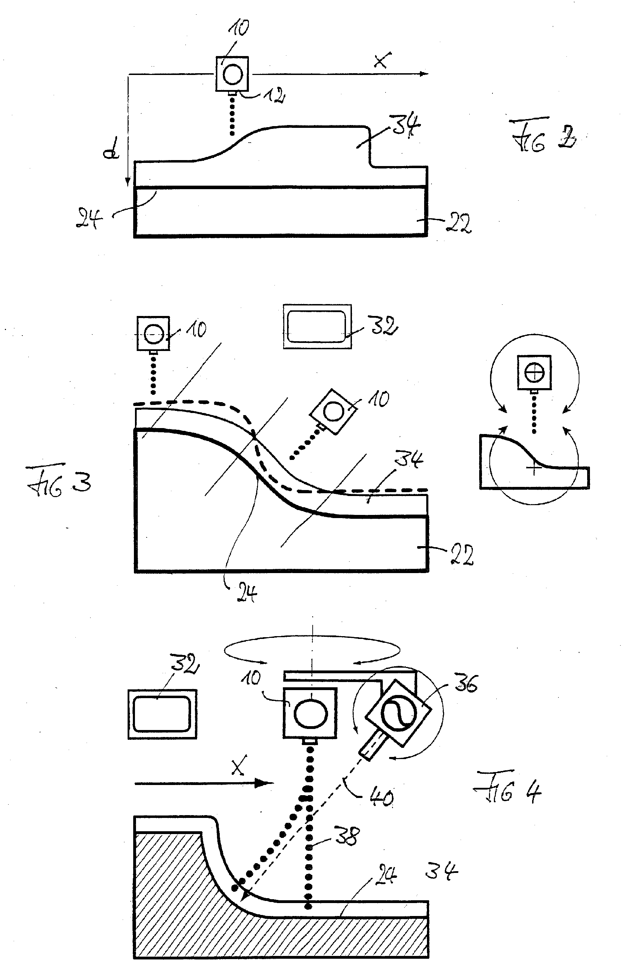

Fig. 2 skizziert eine Möglichkeit, wie auf der Oberfläche 24 eines zu beschichtenden Gegenstands 22 eine Flüssigkeitsschicht 34 unterschiedlicher Dicke d aufgebracht werden kann. X zeigt die Richtung der Relativbewegung zwischen dem Auftragsbauteil 10 und dem Gegenstand 22. Wenn sich das Auftragsbauteil 10 von gemäß Fig. 4 links längs der zu beschichtenden Oberfläche 24 bewegt, wird die je Flächeneinheit aufgebrachte Flüssigkeitsmenge erhöht, indem die von dem Auftragsbauteil 10 abgestrahlte Flüssigkeitsmenge vergrößert wird (Vergrößerung der je Zeiteinheit abgespritzten Flüssigkeitströpfchen) oder die Relativgeschwindigkeit zwischen Auftragsbauteil 10 und Gegenstand 22 vermindert wird oder die Oberfläche mehrfach hintereinander beschichtet wird, indem sich das Auftragsbauteil 10 mehrfach über den jeweiligen Flächenbereich bewegt. Wenn das Auftragsbauteil 10 bzw. die an dessen Unterseite vorgesehenen Düsen 12 sich über die gesamte Breite (senkrecht zur Zeichnungsebene der Fig. 2) erstrecken, werden nur die Düsen 12 des Auftragsbauteils 10 angesteuert, die sich über der zu beschichtenden Oberfläche 24 befinden. Das Auftragsbauteil 10 muss dann entsprechend der Dicke d der bereits aufgebrachten Schicht 33 nur in Z-Richtung (Dickenrichtung) der Schicht 33 bewegt werden, damit der Abstand zwischen den Düsen 12 und der zu beschichtenden Oberflächen zur Erzielung eines wohl definierten Auftrags konstant ist. Wenn das Auftragsbauteil 10 schmaler ist als die zu beschichtende Oberfläche 24, wird das Auftragsbauteil 10 zur flächigen Beschichtung der Oberfläche 24 bzw. eines Bereiches der Oberfläche in Y-Richtung (Breitenrichtung der Oberfläche 24) bewegt. Je nach Auftragsbedingungen ergibt sich eine langsame oder rasche Dickenzu- oder- abnahme der Schicht 34. Es versteht sich, dass diese Art der Änderung der Schichtdicke vorteilhaft bei Flüssigkeiten angewendet werden kann, die rasch nach ihrem Auftrag härten. Dies kann dadurch geschehen, dass Flüssigkeiten mit rasch verdampfenden Lösungsmitteln verwendet werden oder Flüssigkeiten, die bei UV-Bestrahlung härten, wobei eine UV-Bestrahlungseinrichtung in das Auftragsbauteil 10 integriert werden kann, oder beispielsweise auch dadurch, dass aus benachbarten Düsen Flüssigkeiten abgespritzt werden, die bei ihrer gegenseitigen Vermischung bzw. Berührung aushärten.

Fig. 3 zeigt ein Beispiel, bei dem der Gegenstand 22 eine gekrümmte Oberfläche 24 aufweist. Das Auftragsbauteil 10, das zusätzlich verschwenkt werden kann, wird relativ zur Oberfläche 24 vorteilhafterweise derart bewegt, dass der Abstand zwischen den Düsen 12 und der Oberfläche 24 konstant ist und die Abspritzrichtung ständig etwa senkrecht auf der Oberfläche 24 steht. Mit der gestrichelten Linie ist die Dicke einer Flüssigkeitsschicht 34 dargestellt, die zunächst auf die Oberfläche 24 aufgebracht wird. Diese Dicke ist zunächst inhomogen und derart, dass sie sich durch ein Abwärtsfließen der noch nicht ausgehärteten Flüssigkeit längs der Oberfläche 24 vergleichmäßigt, so dass nach dem Aushärten eine Beschichtung mit gleichmäßiger Dicke erzielt wird.

Fig. 4 erläutert ein Verfahren, bei dem dem Auftragsbauteil 10 ein Gebläse 36 zugeordnet ist, das schwenkbar ist, so dass ein von dem Auftragsbauteil 10 abgestrahlter Flüssigkeitsstrahl 38 derart abgelenkt werden kann, dass er jeweils senkrecht auf eine gekrümmte Oberfläche 24 auftrifft. Wenn die Geometrie der Oberfläche 24 bekannt ist, können die Relativbewegungen zwischen der Oberfläche 24 und dem Auftragsbauteil 10 sowie die Bewegung des Gebläses 36 relativ zum Auftragsbauteil 10 von der Steuereinrichtung 30 derart gesteuert werden, dass auf der gekrümmten Oberfläche 24 eine Flüssigkeitsschicht 34 homogener Dichte abgelagert wird, die unter dem Einfluss des vom Gebläse 36 abgestrahlten Luftstrahls 38 rasch trocknet bzw. härtet.

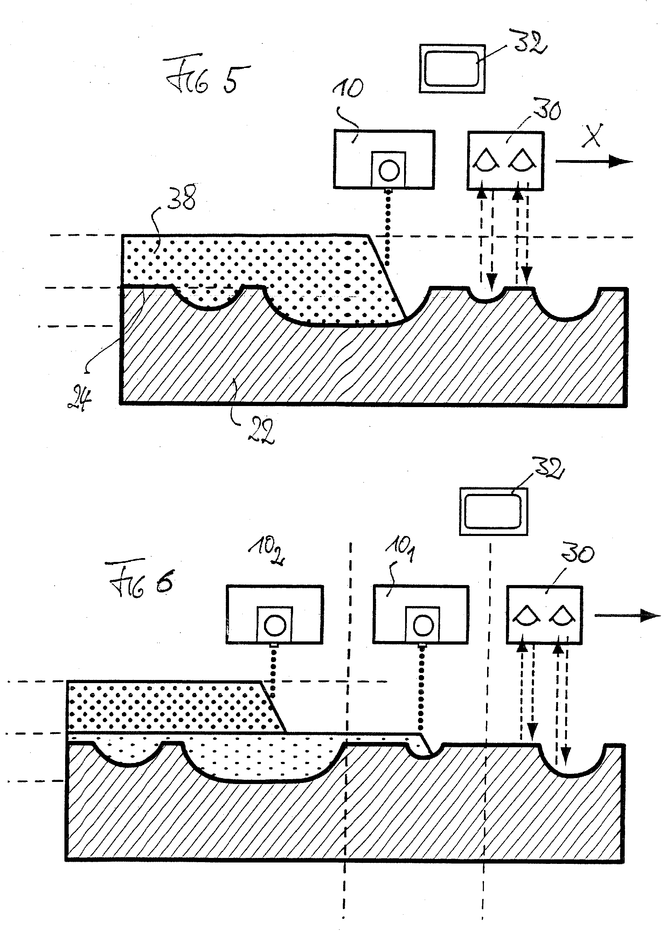

Fig. 5 erläutert ein Verfahren, bei dem eine unebene Oberfläche 24 eines Gegenstandes 22 mit einer Flüssigkeitsschicht 34 beschichtet werden kann, deren Oberfläche eben ist. Die in Richtung der Relativbewegung X vor dem Auftragsbauteil 10 angeordnete Sensoreinrichtung 30 tastet die zu beschichtende Oberfläche 24 ab. Die Abtastdaten, die das Profil der sich an der Sensoreinrichtung 30 vorbeibewegenden Oberfläche 24 angeben, werden der Steuereinrichtung 32 zugeführt, die aufgrund dieser Daten die Düsen des Auftragsbauteils 10 derart steuert, dass eine Flüssigkeitsmenge abgegeben wird, die entsprechend sich an dem Auftragsbauteil 10, das in vorbestimmter räumlicher Beziehung zur Sensoreinrichtung 30 angeordnet ist, vorbeibewegenden Vertiefungen der Oberfläche 24 zunimmt, so dass insgesamt eine ebene Oberfläche der Flüssigkeitsschicht 34 erzielt wird.

Mit der beschriebenen Vorrichtung bzw. dem beschriebenen Verfahren können beispielsweise Beschädigungen einer PKW-Lackschicht ausgebessert werden, indem eine das Auftragsbauteil 10 und die Sensoreinrichtung 30 entsprechende Einheit auf eine Karosserie aufgesetzt wird und ggfs. längs mehrerer Bahnen über die beschädigte Lackschicht geführt wird.

Die Sensoreinrichtung 30 kann einen weiteren Sensor zur Erfassung von Farbwerten der Oberfläche aufweisen. Die den Düsen des Auftragsbauteils 10 zugeführten Färbeflüssigkeiten werden entsprechend den Farbwerten gesteuert.

Fig. 6 entspricht der Fig. 5, enthält jedoch zwei in Bewegungsrichtung X hintereinander angeordnete Auftragsbauteile 10.1 und 10.2, wobei das Auftragsbauteil 10.1 eine Füllerflüssigkeit zum Erzeugen einer ebenen Oberfläche abspritzt und das Auftragsbauteil 10.2 eine Lackschicht abspritzt.

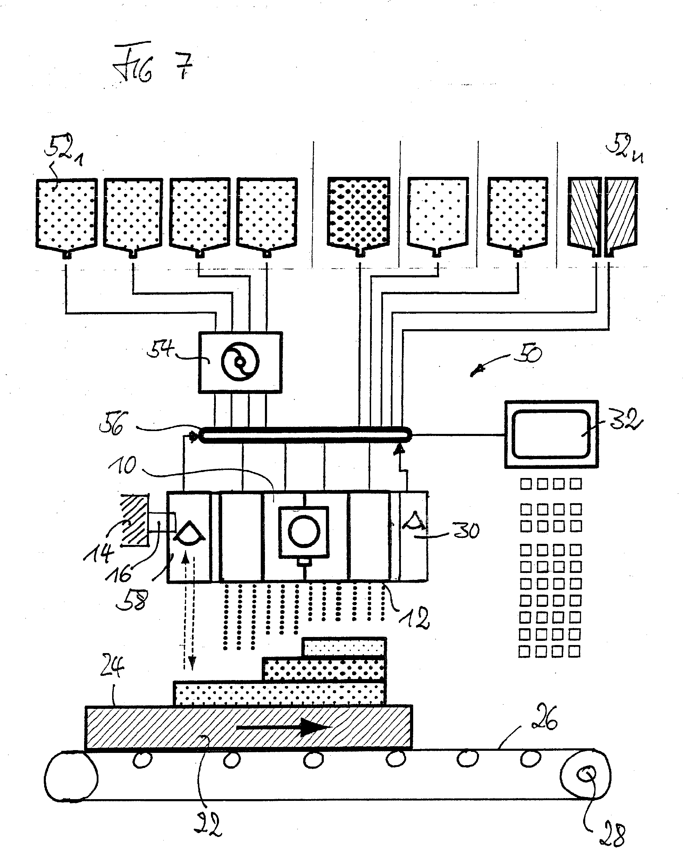

Fig. 7 zeigt den Prinzipaufbau eines digitalen Beschichtungssystems, mit dem unterschiedlichste Flüssigkeiten in unterschiedlichster Weise digital gesteuert auf eine zu beschichtende Oberfläche 24 aufgebracht werden können. Eine Flüssigkeitsversorgung enthält Vorratsbehälter 52.1 bis 52n, in denen unterschiedlichste mittels eines Auftragsbauteils abspritzbare Flüssigkeiten aufgenommen sind, beispielsweise Flüssigkeiten, wie Grundfarben, die unverändert abgespritzt werden, Flüssigkeiten, die vor dem Abspritzen in einer Mischeinheit 54 beispielsweise zum Erzeugen einer Mischfarbe gemischt werden, Flüssigkeiten, die bei ihrer Vermischung härten und aus benachbarten Farbdüsen abgespritzt werden, usw. Zu den Flüssigkeiten, die in den Vorratsbehältern 52 aufgenommen sind, gehören beispielsweise auch farblose Lacke in Matt, Seidenmatt, Seidenglanz und Glanz, lasierende Farben, deckende Farben, Farben und Suspensionen, die in ihren verschiedenen Grundkomponenten bereitgestellt werden und deren aktive Mischung erst nach dem digitalen Auftragen erfolgt, Funktionssuspensionen wie Flüssigkeiten, die durch Beimengung besondere Eigenschaften enthalten, wie elektrische Leitfähigkeit durch Beimischen von Metallteilchen, isolierende Eigenschaften, verschleißfeste Eigenschaften durch Beimischen harter Teilchen, Flüssigkeiten mit beigemischten elektromagnetisch empfindlichen Teilchen, Füller mit volumenaufbauender Wirkung, Primer mit Haft vermittelnden Eigenschaften usw. Die Flüssigkeiten werden in einer Weiche 56 auf im dargestelltem Beispiel vier Zuleitungen zum Auftragsbauteil 10 verteilt. Die Zuleitungen sind mit Gruppen von Düsen verbunden.

Die Mischeinheit 54 ist beispielsweise derart aufgebaut, dass vorbestimmte Flüssigkeitsmengen aus den Vorratsbehältern 52n zusammengemischt und in einem Zwischenbehälter (nicht dargestellt) gespeichert werden, aus dem heraus die Mischfarbe der Weiche 56 beziehungsweise den Düsen 12 zugeführt wird. Dies hat den Vorteil, dass Mischfarben in einer Menge zusammengemischt werden, die dem jeweiligen in der Steuereinrichtung 32 bekannten Bedarf entsprechen, so dass keine Verluste entstehen. Es versteht sich, dass in der Mischeinheit 54 mehrere Mischfarben beziehungsweise Flüssigkeitsgemische in vorbestimmter Menge zusammengemischt und in entsprechenden Zwischenbehältern zwischengespeichert werden können.

Zusätzlich zu der Sensoreinrichtung 30 enthält das System eine Prüfeinrichtung 58, mit der die Oberflächen von bereits aufgebrachten Beschichtungen hinsichtlich Geometrie und/oder Beschaffenheit wie Farbe, Reflexion, Leitfähigkeit usw. erfasst werden können. Die erfassten Daten werden der Steuereinrichtung 32 zur Überprüfung und/oder Steuerung weiterer Beschichtungen zugeführt.

Ein Gegenstand 22, beispielsweise ein Grundsubstrat, mit zu beschichtender Oberfläche 24 kann durch Steuerung der Weiche 56 und der Relativbewegung zwischen dem Auftragsbauteil 10 und dem Gegenstand 22 sowie der Düsen des Auftragsbauteils 10 mittels der Steuereinrichtung 32 in unterschiedlichster Weise beschichtet werden. Die Steuereinrichtung 32 enthält Programme oder ist programmierbar, so dass unterschiedlichste Beschichtungen herstellbar sind, die anhand der Fig. 10 beispielsweise erläutert werden.

Abspritzbare Flüssigkeiten sind für die Anwendung gem. Fig. 7 sowie auch gem. den anderen Figuren beispielsweise Lacke und Farben, die auf Wasser basieren, lösungsmittelhaltig sind, natürliche Harze oder Kunstharze sind, unter UV-Aushärten usw. Den Flüssigkeiten können abriebfeste Beimengungen zugemischt sein, wie beispielsweise Karundpartikel oder Glaspartikel oder Beimengungen, die andere Funktionen bewirken, wie Leitfähigkeit, magnetische Wechselwirkung usw.

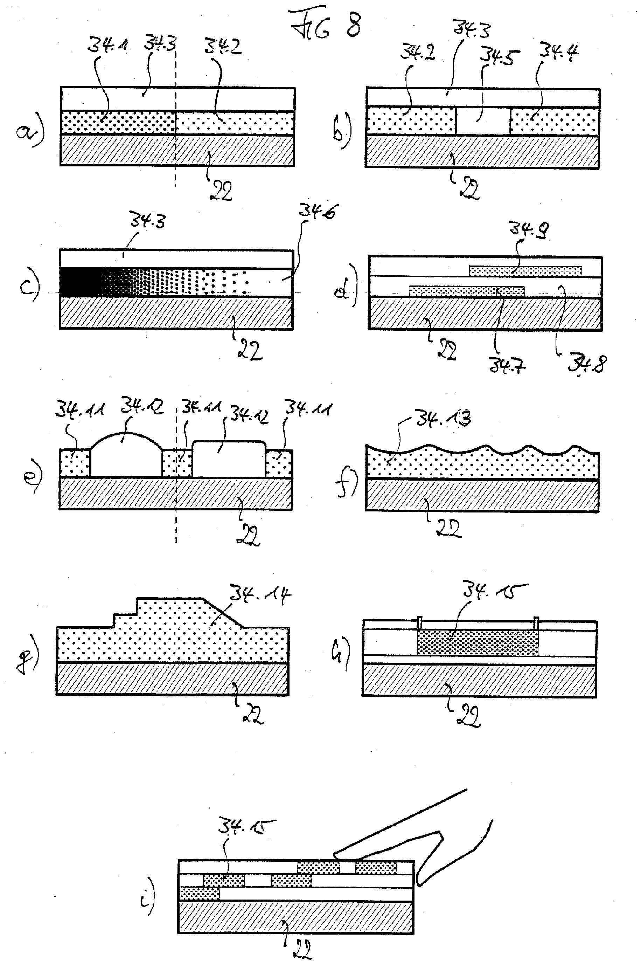

Fig. 8a zeigt ein Beispiel, bei dem die Oberfläche eines Substrates 22 mit zwei unterschiedlichen, sich nicht mischenden, aneinander angrenzenden Farbschichten 34.1 und 34.2 beschichtet ist, über die eine transparente Deckschicht 34.3 aufgebracht ist.

Gemäß der ersten Ausführungsform ist, wie in Fig. 8b gezeigt, ein Substrat 22 mit zwei Farbschichten 34.2, 34.4 beschichtet, zwischen denen sich ein transparenter oder transluzenter Schichtbereich 34.5 befindet. Das Ganze ist mit einer transparenten Deckschicht 34.3 überschichtet.

Mit den Beschichtungsfolgen gemäß Fig. 8a und 8b können beispielsweise Intarsienlackierungen hergestellt werden.

Fig. 8c zeigt eine Schicht 34.6, die dadurch hergestellt ist, dass auf die Oberfläche des Substrates zunächst eine Färbeflüssigkeit einer Farbe und daran anschließend zunehmend eine Färbeflüssigkeit einer anderen Farbe aufgebracht wird, wobei sich die beiden Färbeflüssigkeiten mischen. Auf die Schicht 34.6, die den Mischbereich der Färbeflüssigkeiten enthält, ist wiederum eine transparente Deckschicht 34.3 aufgebracht.

Fig. 8d zeigt ein Beispiel, in dem die Oberfläche des Substrats 22 zunächst mit einem Dekordruck 34.7 versehen wird, dann mit einer transparenten Farbschicht 34.8 versehen wird, die eine ebene Oberfläche für einen erneuten Dekordruck 34.9 bildet, der dann wiederum mit einer transparenten Flüssigkeit derart überschichtet wird, dass sich eine insgesamt ebene Oberfläche bildet. Nach dem Verfahren gemäß Fig. 8d können beispielsweise Bernsteineffekte erzielt werden.

Fig. 8e zeigt ein Beispiel, bei dem zwischen nicht lichtdurchlässigen Bereichen 34.11 lichtdurchlässige Bereiche 34.12 ausgebildet werden, deren Oberflächen unterschiedlich gekrümmt sein können. Es ergeben sich unterschiedlichste Anwendungen. Beispielsweise kann auf diese Weise ein Schalter mit beleuchteten Funktionssymbolen hergestellt werden, indem das Substrat 22 die Außenwand eines innenseitig beleuchteten Schalters bildet und die transparenten Bereiche in Form von Symbolen gestaltet sind. Bei einer gekrümmten Oberfläche ergeben sich zusätzliche Linsenfunktionen, die für eine Vergrößerung verwendet werden können. Allgemein ermöglichen erhabene oder abgesenkte Oberflächen eine haptische Erfassung eines Bedienelements. Weitere Anwendungen sind beispielsweise Fußbodenteile mit erhabenen, Rutsch hemmenden Elementen.

Fig. 8f zeigt ein Bauteil mit einer reliefartigen Beschichtung 34.13. Dateigrundlage kann ein Foto, ein Oberflächenscan einer Vorlage oder eine digital erstellte Vorlage sein. Beispielsweise lassen sich Erhebungen, wie Bilder, Dekore, Formen usw. reliefieren. Beispielsweise können folgende Oberflächen simuliert werden: Pinselstrichstrukturen, Verputztechniken, wie Reibeputz, Spachteltechniken, natürliche und organische Strukturen, Steine oder Krokohaut.

Fig. 8g zeigt eine Schicht 34.14 mit unterschiedlichen Kanten, Höhen und Höhenübergängen.

Fig. 8h zeigt ein Beispiel, bei dem in eine Beschichtung eine Flüssigkeitsschicht 34.15 integriert ist, die elektrisch leitfähig ist, so dass ein Leiternetz mittels digitaler Beschichtungstechniken herstellbar ist. Es können mehrere Netze übereinander angeordnet sein, wie in Fig. 8i dargestellt, wobei die schraffierten Beschichtungsbereiche 34.15 jeweils leitfähig sind. Es können Substrate mit integrierten Antennen, Halbleiterschaltungen usw. hergestellt werden. Durch Veränderung von Widerständen, Kapazitäten oder Induktivitäten zwischen unterschiedlichen elektrisch leitfähigen Schichten bzw. Bahnen können druckempfindliche Schalter usw. hergestellt werden.

Die Beispiele der Fig. 8 dienen nur der Erläuterung der durch ein System gemäß Fig. 7 geschaffenen Möglichkeiten und sind nicht auf die dargestellten Beispiele beschränkt.

Die Programmierung der Steuereinrichtung 32 mit den Daten einer auf den Gegenstand 22 aufzubringenden Beschichtung, beispielsweise auch Lackierung, kann durch unmittelbare Dateneingabe von einem Datenträger oder auch durch Einscannen einer Vorlage geschehen, die beispielsweise von der Sensoreinrichtung 30 abgetastet wird. Mit der Prüfeinrichtung 58 kann dann die auf den Gegenstand 22 aufgebrachte Beschichtung abgetastet werden und die Abtastdaten können mit den von der Sensoreinrichtung erfassten Daten verglichen werden, um das Programm der Steuereinrichtung 32 derart zu verändern, dass die Abweichung zwischen den von der Sensoreinrichtung 30 unter Abtasten einer Vorlage eingescannten Daten und den von der Prüfeinrichtung 58 ermittelten Daten minimal wird.

### Bezugszeichenliste

- 10: Auftragsbauteil
- 12: Düse
- 14: Struktur
- 16: Antriebseinheit
- 18: Flüssigkeitsvorrat
- 20: Leitungen
- 22: Gegenstand
- 24: Oberfläche
- 26: Transportband
- 28: Motor
- 30: Sensoreinrichtung
- 32: Steuereinrichtung
- 34: Schicht
- 36: Gebläse
- 38: Flüssigkeitsstrahl
- 40: Luftstrahl
- 50: Flüssigkeitsversorgung
- 52: Vorratsbehälter
- 54: Mischeinheit
- 56: Weiche
- 58: Prüfeinrichtung

## Patentansprüche

1. Verfahren zum Beschichten einer Oberfläche mittels eines Auftragsbauteils mit einer Mehrzahl von digital angesteuerten Düsen, die Tröpfchen einer aushärtbaren Flüssigkeit zur Erzeugung einer Schicht (34.2; 34.4, 34.5) vorbestimmter Dicke auf der Oberfläche abspritzen,
**dadurch gekennzeichnet, dass**
die Tröpfchen derart abgespritzt werden, dass die Schicht wenigstens zwei Farbschichtbereiche (34.2; 34.4) aufweist, zwischen denen sich seitlich angrenzend ein transparenter oder transluzenter Schichtbereich (34.5) befindet,
der transparente oder transluzente Schichtbereich (34.5) aus einer aushärtbaren Flüssigkeit ausgebildet ist, die verschieden zu aushärtbaren Flüssigkeiten oder einer aushärtbaren Flüssigkeit, aus denen oder der die Farbschichtbereiche ausgebildet sind, ist, und
die Farbschichtbereiche und der transparente oder transluzente Schichtbereich von einer transparente Deckschicht (34.3) überschichtet werden.

2. Verfahren nach Anspruch 1, wobei die Tröpfchen derart abgespritzt werden, dass mindestens zwei der Schichtbereiche unterschiedliche Dicke aufweisen.

3. Verfahren nach Anspruch 1 oder 2, wobei die Flüssigkeit, aus der der transparente oder transluzente Schichtbereich (34.5) ausgebildet wird, sich durch eine oder mehrere der folgenden Eigenschaften von den Flüssigkeiten oder der Flüssigkeit der Farbschichtbereiche unterscheidet: optische Transparenz, elektrische Leitfähigkeit, elektromagnetisches Verhalten, Verschleißfestigkeit.

4. Verfahren nach einem der Ansprüche 1 bis 3, wobei die Dicke eines Schichtbereiches durch Verändern der je Zeiteinheit abgespritzten Flüssigkeitsmenge und/oder durch Verändern der Relativgeschwindigkeit zwischen der zu beschichtenden Oberfläche und den Düsen verändert wird.

5. Verfahren nach einem der Ansprüche 1 bis 4, wobei aneinander angrenzende Schichtbereiche aus nicht miteinander mischbaren Flüssigkeiten bestehen.

6. Bauteil mit einem Substrat (22), auf dessen Oberfläche mittels eines Auftragsbauteils mit einer Mehrzahl von digital angesteuerten Düsen, die Tröpfchen einer aushärtbaren Flüssigkeit auf die Oberfläche abspritzen, eine Schicht (34.2; 34.4, 34.5) vorbestimmter Dicke erzeugt ist,
wobei
die Schicht wenigstens zwei Farbschichtbereiche (34.2; 34.4) aufweist, zwischen denen sich seitlich angrenzend ein transparenter oder transluzenter Schichtbereich (34.5) befindet,
der transparente oder transluzente Schichtbereich (34.5) aus einer ausgehärteten Flüssigkeit ausgebildet ist, die verschieden zu ausgehärteten Flüssigkeiten oder einer ausgehärteten Flüssigkeit, aus denen oder der die Farbschichtbereiche ausgebildet sind, ist, und
die Farbschichtbereiche und der transparente oder transluzente Schichtbereich von einer transparente Deckschicht (34.3) überschichtet sind.

7. Bauteil nach Anspruch 6, wobei mindestens zwei der Schichtbereiche unterschiedliche Dicke aufweisen.

8. Bauteil nach Anspruch 6 oder 7, wobei die Flüssigkeit des transparenten oder transluzenten Schichtbereichs (34.5) sich durch eine oder mehrere der folgenden Eigenschaften von den Flüssigkeiten oder der Flüssigkeit der Farbschichtbereiche unterscheidet: optische Transparenz, elektrische Leitfähigkeit, elektromagnetisches Verhalten, Verschleißfestigkeit.

9. Bauteil nach einem der Ansprüche 6 bis 8, wobei aneinander angrenzende Schichtbereiche aus nicht miteinander mischbaren Flüssigkeiten bestehen.

## Claims

1. A method for coating a surface by means of an application member having a plurality of digitally controlled nozzles spraying droplets of a curable liquid to produce a layer (34.2; 34.4, 34.5) of predetermined thickness on the surface,
**characterized in that**
the droplets are sprayed in such a way that the layer has at least two colour layer regions (34.2; 34.4) between which a transparent or translucent layer region (34.5) is laterally adjacent,
the transparent or translucent layer region (34.5) is formed of a curable liquid different from curable liquids or from a curable liquid from which the colour layer regions are formed, and
the colour layer regions and the transparent or translucent layer region are overlaid by a transparent cover layer (34.3).

2. The method according to claim 1, wherein the droplets are sprayed in such a way that at least two of the layer regions have different thicknesses.

3. The method according to claim 1 or 2, wherein the liquid from which the transparent or translucent layer region (34.5) is formed differs from the liquids or the liquid of the colour layer regions by one or more of the following properties: optical transparency, electrical conductivity, electromagnetic behaviour, wear resistance.

4. The method according to any one of claims 1 to 3, wherein the thickness of a layer region is varied by varying the amount of liquid sprayed per unit time and/or by varying the relative velocity between the surface to be coated and the nozzles.

5. The method according to any one of claims 1 to 4, wherein adjacent layer regions consist of liquids which are immiscible with one another.

6. A member having a substrate (22) on the surface of which a layer (34.2; 34.4, 34.5) of predetermined thickness is produced by means of an application member having a plurality of digitally controlled nozzles which spray droplets of a curable liquid onto the surface,
wherein
the layer has at least two colour layer regions (34.2; 34.4) between which a transparent or translucent layer region (34.5) is located laterally adjacent,
the transparent or translucent layer region (34.5) is formed of a cured liquid different from cured liquids or from a cured liquid from which the colour layer regions are formed, and
the colour layer regions and the transparent or translucent layer region are overlaid by a transparent cover layer (34.3).

7. The member according to claim 6, wherein at least two of the layer regions have different thicknesses.

8. The member according to claim 6 or 7, wherein the liquid of the transparent or translucent layer region (34.5) differs from the liquids or the liquid of the colour layer regions by one or more of the following properties: optical transparency, electrical conductivity, electromagnetic behaviour, wear resistance.

9. The member according to any one of claims 6 to 8, wherein adjacent layer regions consist of liquids which are immiscible with one another.

## Revendications

1. Procédé de revêtement d'une surface à l'aide d'un composant d'application avec une pluralité de buses commandables par voie numérique, qui projettent des gouttelettes d'un liquide durcissable pour la génération d'une couche (34.2 ; 34.4, 34.5) d'épaisseur prédéterminée sur la surface,
**caractérisé en ce que**
les gouttelettes sont projetées de telle manière que la couche présente au moins deux zones de couche de couleur (34.2 ; 34.4), entre lesquelles une zone de couche transparente ou translucide (34.5) est située latéralement adjacente,
la zone de couche transparente ou translucide (34.5) est formée d'un liquide durcissable, qui est différent des liquides durcissables ou d'un liquide durcissable à partir desquels ou duquel les zones de couche de couleur sont formées, et
les zones de couche de couleur et la zone de couche transparente ou translucide sont recouvertes d'une couche de couverture transparente (34.3).

2. Procédé selon la revendication 1, dans lequel les gouttelettes sont projetées de telle manière qu'au moins deux des zones de couche ont des épaisseurs différentes.

3. Procédé selon la revendication 1 ou 2, dans lequel le liquide à partir duquel la zone de couche transparente ou translucide (34.5) est formée, diffère des liquides ou du liquide des zones de couche de couleur par une ou plusieurs des propriétés suivantes : transparence optique, conductivité électrique, comportement électromagnétique, résistance à l'usure.

4. Procédé selon l'une des revendications 1 à 3, dans lequel l'épaisseur d'une zone de couche est modifiée en modifiant la quantité de liquide projetée à chaque unité de temps et/ou en modifiant la vitesse relative entre la surface à revêtir et les buses.

5. Procédé selon l'une des revendications 1 à 4, dans lequel des zones de couches adjacentes sont constituées de liquides non miscibles.

6. Composant avec un substrat (22), à la surface duquel une couche (34.2 ; 34.4, 34.5) d'épaisseur prédéterminée est réalisée à l'aide d'un composant d'application avec une pluralité de buses commandables par voie numérique qui projettent des gouttelettes d'un liquide durcissable sur la surface,
dans lequel
la couche présente au moins deux zones de couche de couleur (34.2 ; 34.4), entre lesquelles une zone de couche transparente ou translucide (34.5) est située latéralement adjacente,
la zone de couche transparente ou translucide (34.5) est formée d'un liquide durci, qui est différent des liquides durcis ou d'un liquide durci à partir desquels ou duquel les zones de couche de couleur sont formées, et les zones de couche de couleur et la zone de couche transparente ou translucide sont recouvertes par une couche de couverture transparente (34.3).

7. Composant selon la revendication 6, dans lequel au moins deux des zones de couches ont des épaisseurs différentes.

8. Composant selon la revendication 6 ou 7, dans lequel le liquide de la zone de couche transparente ou translucide (34.5) diffère des liquides ou du liquide des zones de couche de couleur par une ou plusieurs des propriétés suivantes : transparence optique, conductivité électrique, comportement électromagnétique, résistance à l'usure.

9. Composant selon l'une des revendications 6 à 8, dans lequel des zones de couches adjacentes sont constituées de liquides non miscibles.
